(19) Europäisches Patentamt
European Patent Office
Office européen des brevets

(11) **EP 1 430 596 B1**

(12) **EUROPÄISCHE PATENTSCHRIFT**

(45) Veröffentlichungstag und Bekanntmachung des Hinweises auf die Patenterteilung:
**05.01.2005 Patentblatt 2005/01**

(21) Anmeldenummer: **02754418.8**

(22) Anmeldetag: **23.07.2002**

(51) Int Cl.⁷: **H03F 1/30**, H03F 3/45

(86) Internationale Anmeldenummer:
**PCT/DE2002/002707**

(87) Internationale Veröffentlichungsnummer:
**WO 2003/028207 (03.04.2003 Gazette 2003/14)**

(54) **TEMPERATURSTABILISIERTE VERSTÄRKERSCHALTUNG**

TEMPERATURE-STABILISED AMPLIFIER CIRCUIT

CIRCUIT AMPLIFICATEUR THERMOSTABLE

(84) Benannte Vertragsstaaten:
**DE**

(30) Priorität: **25.09.2001 DE 10147101**

(43) Veröffentlichungstag der Anmeldung:
**23.06.2004 Patentblatt 2004/26**

(73) Patentinhaber: **Infineon Technologies AG
81669 München (DE)**

(72) Erfinder: **MÜLLAUER, Markus
9360 Friesach (AT)**

(74) Vertreter: **Lange, Thomas, Dr.
Patentanwälte
Lambsdorff & Lange
Dingolfinger Strasse 6
81673 München (DE)**

(56) Entgegenhaltungen:
EP-A- 0 961 409          US-A- 4 636 742
US-A- 5 801 584          US-A- 6 107 887

**Beschreibung**

Die Erfindung bezieht sich auf eine Schaltung zur Verstärkung einer Eingangsspannung in eine Ausgangsspannung mit einem temperaturstabilisierten Verstärkungsfaktor.

Verstärkerschaltungen weisen häufig das Problem auf, dass sie temperaturabhängige Bauelemente enthalten, was zur Folge hat, dass die Ausgangssignale der Verstärkerschaltung ebenfalls eine Funktion der Betriebstemperatur sind.

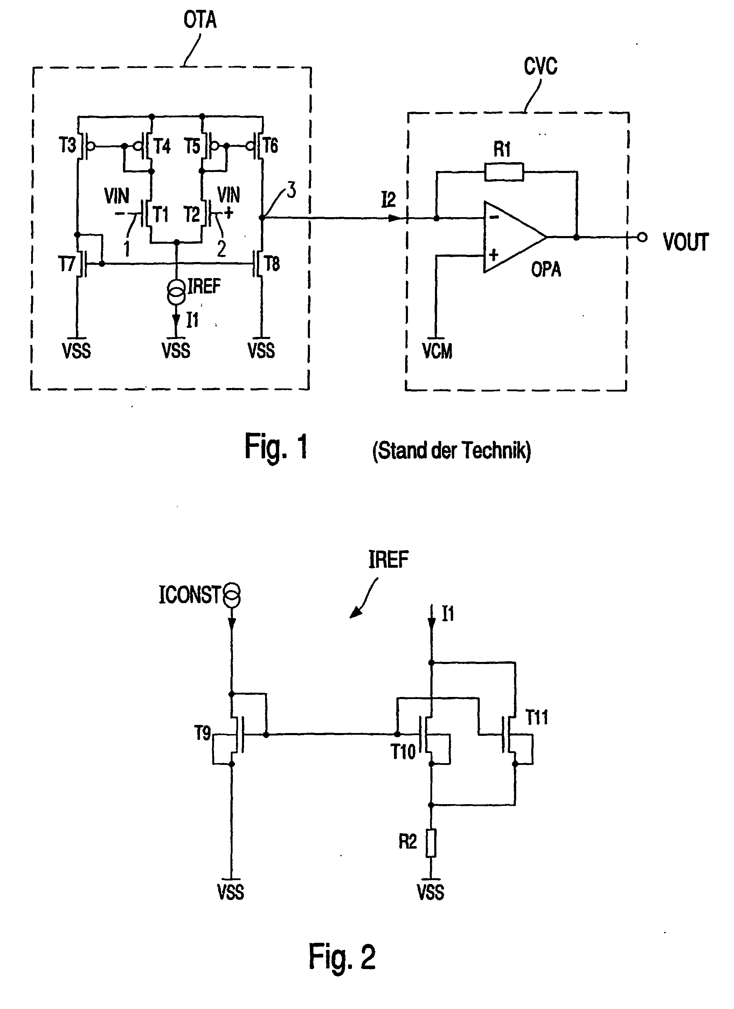

In Fig. 1 ist ein schematisches Schaltbild einer auf CMOS (Complementary Metal-Oxid-Semiconductor)-Technologie basierenden Verstärkerschaltung gezeigt. Die Verstärkerschaltung enthält einen Transkonduktanzverstärker OTA, welcher eine Eingangsspannung VIN in einen Strom I2 umsetzt. Der Strom I2 wird von einem Operationsverstärker OPA, der mit einem Widerstand R1 als Strom-Spannungs-Wandler CVC beschaltet ist, in eine Ausgangsspannung VOUT umgewandelt.

Der Transkonduktanzverstärker OTA weist neben hochohmigen Eingängen 1 und 2 auch einen hochohmigen Ausgang 3 auf. Der Transkonduktanzverstärker OTA verhält sich daher wie eine Stromquelle, sodass der am Ausgang 3 auskoppelbare Strom I2 durch die Eingangsspannung VIN gemäß folgender Gleichung (1) gesteuert wird:

$$I2 = S * VIN, \qquad (1)$$

wobei S für die Steilheit des Transkonduktanzverstärkers OTA steht und durch das Differential des Stroms I2 nach der Eingangsspannung VIN im Arbeitspunkt gegeben ist.

Im seinem Inneren weist der Transkonduktanzverstärker OTA eine Differenzverstärkerstufe auf, welche eine Stromquelle IREF sowie Transistoren T1 und T2 umfasst. An den Gate-Anschlüssen der Transistoren T1 und T2 liegt die Eingangsspannung VIN an. Des Weiteren umfasst der Transkonduktanzverstärker OTA drei Stromspiegel, welche mit Transistoren T3 und T4, T5 und T6 bzw. T7 und T8 aufgebaut sind. Die Transistoren T1, T2, T7 und T8 sind n-Kanal-MOSFETs, während die Transistoren T3, T4, T5 und T6 p-Kanal-MOSFETs sind.

Der Strom I2 wird durch den Operationsverstärker OPA mittels des Widerstands R1 gemäß folgender Gleichung (2) in die Ausgangsspannung VOUT umgewandelt:

$$VOUT = R1 * I2 + VCM, \qquad (2)$$

wobei VCM die Mittenspannung angibt. Eine Kombination der Gleichungen (1) und (2) liefert Gleichung (3) als Übertragungsfunktion der vorliegenden Verstärker-schaltung:

$$VOUT = S * R1 * VIN + VCM, \qquad (3)$$

wobei das Produkt aus der Steilheit S und dem Widerstand R1 den Verstärkungsfaktor der Verstärkerschaltung angibt.

Bei CMOS-Herstellungsprozessen werden lineare Widerstände häufig durch Abscheidung von Polysilizium-Material erzeugt. Der Temperaturkoeffizient solcher Widerstände, welcher die Widerstandsänderung mit der Temperatur angibt, ist mit dem Widerstandswert pro Flächeneinheit des Polysiliziums korreliert. Bei nur kleinen Widerstandswerten pro Flächeneinheit ist der Temperaturkoeffizient positiv. Der Temperaturkoeffizient sinkt mit steigendem Widerstandswert pro Flächeneinheit und wird für große Widerstandswerte pro Flächeneinheit negativ.

Bei der vorliegenden Verstärkerschaltung muss der Widerstand R1 hochohmig sein. Ansonsten müsste die Steilheit S des Transkonduktanzverstärkers OTA groß sein, um dennoch einen akzeptablen Verstärkungsfaktor der Verstärkerschaltung zu erzielen. Dieses würde aber wiederum einen inakzeptabel großen Stromverbrauch des Transkonduktanzverstärkers OTA nach sich ziehen.

Ein hochohmiger Widerstand R1 wird in CMOS-Technologie zur Vermeidung von zu großem Flächenverbrauch durch Polysilizium mit einem hohen Widerstandswert pro Flächeneinheit hergestellt. Nachteilig daran ist allerdings der daraus resultierende negative Temperaturkoeffizient des Widerstands R1. Da die Steilheit S des Transkonduktanzverstärkers OTA mit steigender Temperatur ebenfalls abnimmt, ist der Verstärkungsfaktor der vorliegenden Verstärkerschaltung stark temperaturabhängig. Diese Eigenschaft der Verstärkerschaltung ist besonders nachteilig, wenn die Verstärkerschaltung in einem weiten Temperaturbereich betrieben wird. Hinzu kommt, dass auch Herstellungstoleranzen des hochohmigen Widerstands R1 den Verstärkungsfaktor beeinflussen.

Die vorliegende Verstärkerschaltung wird auch dazu genutzt, Wechselspannungen zu verstärken. Die Leerlauffrequenz der Verstärkerschaltung hängt ebenfalls von dem Verstärkungsfaktor ab. Bei einem über einen gewissen Temperaturbereich instabilen Verstärkungsfaktor führt dieses zu Stabilitätsproblemen der Verstärkerschaltung.

Bisherige Lösungen zu den vorstehend genannten Problemen beinhalten die Verwendung eines Widerstands R1 mit einem nur kleinen Temperaturkoeffizienten und geringen Herstellungstoleranzen sowie die Verwendung einer temperaturunabhängigen Stromquelle IREF, woraus sich eine nur geringe temperaturabhängige Steilheit S des Transkonduktanzverstärkers OTA ergibt. Durch diesen Lösungsansatz wird die Temperaturabhängigkeit des Verstärkungsfaktors zwar minimiert, jedoch wird die Fläche der Schaltung groß, weil Polysilizium-Widerstände mit niedrigem spezifischen Widerstand verwendet werden müssen, oder aber es müssen durch zusätzliche Prozessschritte temperaturstabile hochohmige Widerstände erzeugt werden. Beide Maßnahmen sind aufwendig und kostenintensiv.

Bei einem weiteren Lösungsansatz wird im Gegensatz zu dem soeben beschriebenen Lösungsansatz auf die Temperaturunabhängigkeit der Stromquelle IREF verzichtet und lediglich ein Widerstand R1 mit einem kleinen Temperaturkoeffizienten und geringen Herstellungstoleranzen verwendet. Allerdings darf in diesem Fall die Verstärkerschaltung nur in einem relativ kleinen Temperaturbereich betrieben werden.

Aufgabe der Erfindung ist es daher, eine Verstärkerschaltung zu schaffen, welche über einen weiten Temperaturbereich einen temperaturstabilisierten Verstärkungsfaktor aufweist. Die Temperaturstabilität des Verstärkungsfaktors soll insbesondere auch bei der Verwendung hochohmiger Widerstände mit großen Temperaturkoeffizienten gewährleistet sein.

Die der Erfindung zugrunde liegende Aufgabenstellung wird durch die Merkmale des unabhängigen Patentanspruchs 1 gelöst. Vorteilhafte Weiterbildungen und Ausgestaltungen sind in den Unteransprüchen angegeben.

Durch die erfindungsgemäße Verstärkerschaltung wird eine Eingangsspannung mittels eines Gesamtverstärkungsfaktors in eine Ausgangsspannung umgewandelt. Der Gesamtverstärkungsfaktor ist ein Produkt aus einem ersten Verstärkungsfaktor und einem zweiten Verstärkungsfaktor. Die Verstärkerschaltung umfasst erste Mittel, die zur Erzeugung eines Zwischensignals in Form eines Zwischenstroms aus der Eingangsspannung und dem ersten Verstärkungsfaktor dienen. Des Weiteren umfasst die Verstärkerschaltung zweite Mittel, mit denen die Ausgangsspannung aus dem Zwischensignal und dem zweiten Verstärkungsfaktor erzeugt werden.

Die ersten Mittel beinhalten eine Stromquelle und einen Transkonduktanzverstärker, an dessen Eingang die Eingangsspannung anliegt und an dessen Ausgang der Zwischenstrom auskoppelbar ist. Der Transkonduktanzverstärker beinhaltet einen unterhalb der Schwellenspannung betriebenen und über den Source-Anschluss von der Stromquelle gespeisten signalverstärkenden MOS-Transistor. Dabei weist der von der Stromquelle bereitgestellte Strom und davon abhängig auch der erste Verstärkungsfaktor gegenüber dem zweiten Verstärkungsfaktor eine gegenläufige Temperaturabhängigkeit auf.

Der Vorteil der erfindungsgemäßen Verstärkerschaltung begründet sich auf die gegenläufigen Temperaturabhängigkeiten des ersten und des zweiten Verstärkungsfaktors. Bei einer Temperaturänderung steigt einer der beiden Verstärkungsfaktoren an und der andere Verstärkungsfaktor fällt, sodass sich insgesamt ein im Wesentlichen temperaturunabhängiges Produkt der beiden Verstärkungsfaktoren und somit ein temperaturstabilisierter Gesamtverstärkungsfaktor ergeben.

Durch die erfindungsgemäße Verstärkerschaltung wird folglich eine Kompensation der Temperaturabhängigkeiten der beiden Verstärkungsfaktoren erzielt, wodurch sich eine Temperaturunabhängigkeit des Gesamtverstärkungsfaktors über einen weiten Temperaturbereich ergibt. Des Weiteren wird eine temperaturabhängige Variation der Übertragungsfrequenz durch die erfindungsgemäße Verstärkerschaltung unterdrückt.

Der Kompensationseffekt ergibt sich bei der erfindungsgemäßen Verstärkerschaltung im Besonderen dadurch, dass der signalverstärkende MOS-Transistor des Transkonduktanzverstärkers unterhalb der Schwellspannung betrieben wird. Nur dann ist die Steilheit S des Transkonduktanzverstärkers proportional zu dem Strom der Stromquelle. Dies bedeutet, dass sich die

Temperaturabhängigkeit des von der Stromquelle bereitgestellten Stroms direkt auf die Temperaturabhängigkeit der Steilheit des Transkonduktanzverstärkers überträgt, so dass sich ein temperaturstabilisierter Gesamtverstärkungsfaktor gemäß Gleichung (3) ergibt.

Sofern die ersten und zweiten Mittel zur Generierung der Verstärkungsfaktoren hochohmige Widerstände mit großen Temperaturkoeffizienten aufweisen, ergibt sich dennoch aufgrund der erfindungsgemäßen Kompensation der Temperaturabhängigkeiten der beiden Verstärkungsfaktoren ein temperaturunabhängiger Gesamtverstärkungsfaktor.

Gemäß einer vorteilhaften Ausgestaltung der Erfindung enthal-. ten die zweiten Mittel einen Strom-Spannungs-Wandler, welcher einen Operationsverstärker und einen in den Rückkoppelzweig des Operationsverstärkers geschalteten Wandlerwiderstand aufweist. Der Strom-Spannungs-Wandler dient zur Umwandlung des von dem Transkonduktanzverstärker erzeugten Zwischenstroms in die Ausgangsspannung.

Eine besonders vorteilhafte Ausgestaltung des Erfindung ist dadurch gekennzeichnet, dass der von der Stromquelle bereitgestellte Strom und der Wandlerwiderstand gegenläufige Temperaturabhängigkeiten aufweisen. Die Temperaturabhängigkeit des von der Stromquelle bereitgestellten Stroms überträgt sich auf die Temperaturabhängigkeit der Steilheit des Transkonduktanzverstärkers. Gemäß Gleichung (3) ergibt sich aus der vorstehend genannten Forderung ein temperaturstabilisierter Gesamtverstärkungsfaktor der Verstärkerschaltung.

Zur schaltungstechnischen Realisierung einer Stromquelle, deren Strom ein dem Wandlerwiderstand gegenläufiges Temperaturverhalten aufweist, ist es besonders vorteilhaft, wenn die Stromquelle eine Stromquellenbank umfasst, deren Eingangstransistor mit einem temperaturstabilisierten Eingangsstrom gespeist wird und die mindestens zwei parallel geschaltete Ausgangstransistoren aufweist. Die durch die Drain-Source-Strecken der Ausgangstransistoren erzeugten Ausgangsströme fließen durch mindestens einen Widerstand und speisen gemeinsam den Differenzverstärker des Transkonduktanzverstärkers.

Durch die Parallelschaltung der mindestens zwei Ausgangstransistoren ist die Gate-Source-Spannung der mindestens zwei Ausgangstransistoren geringer als die Gate-Source-Spannung des Eingangstransistors. Die aufgrund der unterschiedlichen Gate-Source-Spannungen erzeugte Spannungsdifferenz fällt über dem mindestens einen Widerstand ab. Je größer dabei die Anzahl der parallel geschalteten Ausgangstransistoren ist, umso größer ist die Spannung, die über dem mindestens einen Widerstand abfällt.

Der Strom, welcher durch die Drain-Source-Strecken der mindestens zwei Ausgangstransistoren gemeinsam erzeugt wird und den Differenzverstärker des Transkonduktanzverstärkers speist, ist in seiner Temperaturabhängigkeit von der Temperaturabhängigkeit des mindestens einen Widerstands bestimmt, und zwar verhält sich die Temperaturabhängigkeit dieses Stroms gegenläufig zu der Temperaturabhängigkeit des mindestens einen Widerstands. Dadurch verhält sich auch die Temperaturabhängigkeit des Zwischenstroms gegenläufig zu dem mindestens einen Widerstand und somit ebenfalls gegenläufig zu dem Wandlerwiderstand, was einen temperaturstabilisierten Gesamtverstärkungsfaktor zur Folge hat.

Sofern der Eingangstransistor und die mindestens zwei Ausgangstransistoren gut aufeinander abgestimmt sind, werden dadurch auch durch Herstellungstoleranzen verursachte Spannungsvariationen behoben.

Ein temperaturstabilisierter Eingangsstrom lässt sich beispielsweise durch einen BGR (Band Gap Reference)-Schaltkreis besonders einfach erzeugen. Derartige Schaltkreise sind bereits in vielen Geräten vorhanden und können vorteilhafterweise auch für die erfindungsgemäße Verstärkerschaltung verwendet werden.

Die erfindungsgemäße Verstärkerschaltung ist besonders dafür geeignet, auf einem gemeinsamen Substrat integriert zu sein und insbesondere mittels CMOS-Technologie hergestellt zu werden. Bei einem derartigen Herstellungsprozess können sowohl der wandlerwiderstand als auch der mindestens eine Widerstand der Stromquelle durch Abscheidung von Polysilizium-Material mit einem hohen Widerstandswert pro Flächeneinheit erzeugt werden. Dadurch werden ein geringer Stromverbrauch des Transkonduktanzverstärkers und eine gute Temperaturstabilität des Gesamtverstärkungsfaktors gewährleistet. Ferner weisen in diesem Fall die beiden linearen Widerstände vergleichbare (negative) Temperaturkoeffizienten und Herstellungstoleranzen auf.

Das erfindungsgemäße Verfahren dient zur Verstärkung einer Eingangsspannung in eine Ausgangsspannung. Dabei ist der Gesamtverstärkungsfaktor, welcher die Verstärkung der Eingangsspannung in die Ausgangsspannung angibt, ein Produkt aus einem ersten und einem zweiten Verstärkungsfaktor

Bei dem erfindungsgemäßen Verfahren wird zunächst ein Zwischensignal in Form eines Zwischenstroms aus der Eingangsspannung und dem ersten Verstärkungsfaktor erzeugt. Dies geschieht mittels einer Stromquelle und einem Transkonduktanzverstärker, an dessen Eingängen die Eingangsspannung anliegt und an dessen Ausgang ein Zwischenstrom auskoppelbar ist. Der von der Stromquelle bereitgestellte Strom und davon abhängig auch der erste Verstärkungsfaktor weisen gegenläufige Temperaturabhängigkeiten gegenüber dem zweiten Verstärkungsfaktor auf. Ein über den Source-Anschluß von der Stromquelle gespeister MOS-Transistor des Transkonduktanzverstärkers wird dabei unterhalb der Schwellspannung betrieben. Anschließend erfolgt die Generierung der Ausgangsspannung aus dem Zwischensignal und dem zweiten Verstärkungsfaktor. Der Vorteil des erfindungsgemäßen Verfahrens liegt wieder in den gegenläufigen Temperaturabhängigkeiten des ersten und des zweiten Verstärkungsfaktors. Dieser Kompensationseffekt wird, wie bereits beschrieben, durch den Betrieb des MOS-Transistors unterhalb der Schwellspannung ermöglicht. Daraus ergibt sich insgesamt ein über einen weiten Betriebstemperaturbereich stabilisierter Gesamtverstärkungsfaktor.

Die Erfindung wird nachfolgend unter Bezugnahme auf die Zeichnungen näher erläutert. In diesen zeigen:

Fig. 1      ein schematisches Schaltbild einer Verstärkerschaltung gemäß dem Stand der Technik; und

Fig. 2      ein schematisches Schaltbild eines Ausführungsbeispiels der erfindungsgemäßen Stromquelle zur Speisung des Differenzverstärkers des in Fig. 1 gezeigten Transkonduktanzverstärkers.

Fig. 2 zeigt ein schematisches Schaltbild eines Ausführungsbeispiels einer erfindungsgemäßen Stromquelle IREF, die zur Bereitstellung eines Stroms 11 dient, der für die in Fig. 1 gezeigte Differenzverstärkerstufe des Transkonduktanzverstärkers OTA verwendet wird. Die Stromquelle IREF enthält einen Transistor T9, dessen Source-Drain-Strecke zwischen eine Stromquelle ICONST und ein gemeinsames festes Potential, insbesondere eine Masse VSS, geschaltet ist. Der Transistor T9 ist als Eingangstransistor einer Stromquellenbank mit Transistoren T10 und T11 als Ausgangstransistoren über ihre Gate-Anschlüsse verbunden. Des Weiteren ist der Drain-Anschluss des Transistors T9 mit seinem Gate-Anschluss verbunden. Die Transistoren T10 und T11 sind an ihren Drain- bzw. Source-Anschlüssen jeweils miteinander verbunden. Zwischen die Source-Anschlüsse der Transistoren T10 und T11 und die Masse VSS ist ein Widerstand R2 geschaltet. Auf der Seite der Drain-Anschlüsse der Transistoren T10 und T11 wird der Strom I1 erzeugt. Die Transistoren T9, T10 und T11 sind beispielsweise n-Kanal-MOSFETs.

Eine Voraussetzung für das erfindungsgemäße Funktionieren der vorliegenden Schaltung ist es, dass die Stromquelle ICONST einen temperaturunabhängigen Strom bereitstellt. Diese Voraussetzung wird beispielsweise von einem BGR-Schaltkreis erfüllt. Der von der Stromquelle ICONST erzeugte Strom wird von dem Transistor T9 in die Drain-Source-Strecken der Transistoren T10 und T11 gespiegelt.

Dabei ist die Gate-Source-Spannung des Transistors T9 größer als die Gate-Source-Spannungen der Transistoren T10 und T11. Die Differenz dieser Gate-Source-Spannungen fällt über dem Widerstand R2 ab. Je mehr Transistoren wie die Transistoren T10 und T11 als Ausgangstransistoren der Stromquellenbank parallel geschaltet sind, desto größer ist die Spannung, die über dem Widerstand R2 abfällt. Desto größer ist auch die Temperaturabhängigkeit des Stroms 11 von dem Widerstand R2, da der Strom 11 eine Funktion von 1/R2 ist.

Des Weiteren ist die Steilheit eines CMOS-Transistors proportional zu dem durch seine Drain-Source-Strecke fließenden Strom, sofern der CMOS-Transistor unterhalb der Schwellenspannung betrieben wird. Da sich der optimale Arbeitspunkt für die die CMOS-Transistoren T1 und T2 aufweisende Differenzverstärkerstufe zwischen dem Unterschwellspannungsbereich und dem Spannungsbereich mit leichter Inversion befindet, ist die Steilheit S des Transkonduktanzverstärkers OTA ebenfalls proportional zu dem Strom I1 und gemäß dem vorstehenden Absatz somit eine Funktion von 1/R2. Daraus folgt, dass der Verstärkungsfaktor der in Fig. 1 gezeigten Verstärkerschaltung mit der vorliegenden erfindungsgemäßen Stromquelle IREF proportional zu dem Widerstand R1 und indirekt proportional zu dem Widerstand R2 ist. Da die Widerstände R1 und R2 aufgrund ihrer Bauart gleiche Temperaturabhängigkeiten aufweisen, ist der Verstärkungsfaktor über einen weiten Temperaturbereich temperaturunabhängig.

**Patentansprüche**

1. Verstärkerschaltung mit einem temperaturstabilisierten Gesamtverstärkungsfaktor, welcher die Verstärkung einer Eingangsspannung (VIN) in eine Ausgangsspannung (VOUT) angibt und welcher ein Produkt aus einem ersten Verstärkungsfaktor (S) und einem zweiten Verstärkungsfaktor (R1) ist, wobei die Verstärkerschaltung aufweist:

   - erste Mittel zur Erzeugung eines Zwischensignals in Form eines Zwischenstroms (I2) aus der Eingangsspannung (VIN) und dem ersten Verstärkungsfaktor (S), welche

      - eine Stromquelle (IREF) und
      - einen Transkonduktanzverstärker (OTA) aufweisen, an dessen Eingang (1, 2) die Eingangsspannung anliegt und an dessen Ausgang (3) der Zwischenstrom (I2) auskoppelbar ist, wobei

      - ein über den Source-Anschluss von der Stromquelle (IREF) gespeister signalverstärkender MOS-Transistor (T1, T2) des Tanskonduktanzverstärkers unterhalb der Schwellenspannung betrieben wird, und

   - zweite Mittel zur Erzeugung der Ausgangsspannung (VOUT) aus dem Zwischensignal (I2) und dem zweiten Verstärkungsfaktor (R1), und wobei
   - der von der Stromquelle (IREF) bereitgestellte Strom (I1) und davon abhängig auch der erste Verstärkungsfaktor (S) gegenläufige Temperaturabhängigkeiten gegenüber dem zweiten Verstärkungsfaktor (R1) aufweisen.

2. Verstärkerschaltung nach Anspruch 1, **dadurch gekennzeichnet,**

   - **dass** die Stromquelle (IREF) einen Differenzverstärker des Transkonduktanzverstärkers (OTA) speist.

3. Verstärkerschaltung nach Anspruch 1 oder 2, **dadurch gekennzeichnet,**

   - **dass** die zweiten Mittel einen mit einem Wandlerwiderstand (R1) als Strom-Spannungs-Wandler (CVC) beschalteten Operationsverstärker (OPA) aufweisen, welcher den Zwischenstrom (I2) in die Ausgangsspannung (VOUT) umwandelt.

4. Verstärkerschaltung nach Anspruch 3, **dadurch gekennzeichnet,**

   - **dass** der von der Stromquelle (IREF) bereitgestellte Strom (I1) und der Wandlerwiderstand (R1) gegenläufige Temperaturabhängigkeiten aufweisen.

5. Verstärkerschaltung nach einem oder mehreren der Ansprüche 2 bis 4, **dadurch gekennzeichnet,**

   - **dass** die Stromquelle (IREF) eine Stromquellenbank umfasst, deren Eingangstransistor (T9) mit einem temperaturstabilisierten Eingangsstrom (ICONST) gespeist wird und die als Ausgangstransistoren mindestens zwei parallel geschaltete Transistoren (T10, T11) aufweist, wobei die durch die Drain-Source-Strecken der Ausgangstransistoren (T10, T11) erzeugten Ausgangsströme durch mindestens einen Widerstand (R2) fließen und gemeinsam den Differenzverstärker des Transkonduktanzverstärkers (OTA) speisen.

6. Verstärkerschaltung nach einem oder mehreren der vorhergehenden Ansprüche, **dadurch gekennzeichnet,**

   - **dass** die ersten und die zweiten Mittel auf einem gemeinsamen Substrat integriert sind, und die Verstärkerschaltung insbesondere eine CMOS-Verstärkerschaltung ist.

7. Verstärkerschaltung nach Ansprüchen 5 und 6, **dadurch gekennzeichnet,**

   - **dass** der Wandlerwiderstand (R1) und der mindestens eine Widerstand (R2) der Stromquelle (IREF) integrierte lineare Widerstände sind, welche insbesondere einen hohen Temperaturkoeffizienten aufweisen.

8. Verfahren zur Verstärkung einer Eingangsspannung (VIN) in eine Ausgangsspannung (VOUT) mit einem temperaturstabilisierten Gesamtverstärkungsfaktor, welcher die Verstärkung der Eingangsspannung (VIN) in die Ausgangsspannung (VOUT) angibt und welcher ein Produkt aus einem ersten Verstärkungsfaktor (S) und einem zweiten Verstärkungsfaktor (R1) ist, wobei folgende Schritte durchlaufen werden:

   (1) Erzeugen eines Zwischensignals in Form eines Zwischenstroms (I2) aus der Eingangsspannung (VIN) und dem ersten Verstärkungsfaktor (S) mittels einer Stromquelle (IREF) und einem Transkonduktanzverstärker (OTA), an dessen Eingängen (1, 2) die Eingangsspannung (VIN) anliegt und an dessen Ausgang (3) der Zwischenstrom auskoppelbar ist, wobei der von der Stromquelle (IREF) bereitgestellte Strom (I1) und davon abhängig auch der erste Verstärkungsfaktor (S) gegenläufige Temperaturabhängigkeiten gegenüber dem zweiten Verstärkungsfaktor (R1) aufweisen, und ein über den Source-Anschluß von der Stromquelle (IREF) gespeister MOS-Transistor (T1, T2) des Transkonduktanzverstärkers unterhalb der Schwellenspannung betrieben wird; und
   (2) Erzeugen der Ausgangsspannung (VOUT) aus dem Zwischensignal (I2) und dem zweiten Verstärkungsfaktor (R1).

## Claims

1. Amplifier circuit with a temperature-stabilized overall gain factor, which specifies the amplification of an input voltage (VIN) into an output voltage (VOUT) and which is a product of a first gain factor (S) and a second gain factor (R1), the amplifier circuit having:

   - first means for generating an intermediate signal in the form of an intermediate current (I2) from the input voltage (VIN) and the first gain factor (S), which have

     - a current source (IREF) and
     - a transconductance amplifier (OTA), at whose input (1, 2) the input voltage is present and at whose output (3) the intermediate current (I2) can be coupled out,

       - a signal-amplifying MOS transistor (T1, T2) of the transconductance amplifier which is fed from the current source (IREF) via the source terminal being operated below the threshold voltage, and

   - second means for generating the output voltage (VOUT) from the intermediate signal (I2) and the second gain factor (R1), and
   - the current (I1) provided by the current source (IREF) and, dependent thereon, also the first gain factor (S) having opposite temperature dependencies with respect to the second gain factor (R1).

2. Amplifier circuit according to Claim 1, **characterized**

   - **in that** the current source (IREF) feeds a differential amplifier of the transconductance amplifier (OTA).

3. Amplifier circuit according to Claim 1 or 2, **characterized**

   - **in that** the second means have an operational amplifier (OPA), which is connected up with a converter resistor (R1) as a converter (CVC) and converts the intermediate current (I2) into the output voltage (VOUT).

4. Amplifier circuit according to Claim 3, **characterized**

- **in that** the current (I1) provided by the current source (IREF) and the converter resistor (R1) have opposite temperature dependencies.

5. Amplifier circuit according to one or more of Claims 2 to 4, **characterized**

   - **in that** the current source (IREF) comprises a current source bank whose input transistor (T9) is fed with a temperature-stabilized input current (ICONST) and which has at least two transistors (T10, T11) connected in parallel as output transistors, the output currents generated by the drain-source paths of the output transistors (T10, T11) flowing through at least one resistor (R2) and jointly feeding the differential amplifier of the transconductance amplifier (OTA).

6. Amplifier circuit according to one or more of the preceding claims, **characterized**

   - **in that** the first and the second means are integrated on a common substrate, and the amplifier circuit is, in particular, a CMOS amplifier circuit.

7. Amplifier circuit according to Claims 5 and 6, **characterized**

   - **in that** the converter resistor (R1) and the at least one resistor (R2) of the current source (IREF) are integrated linear resistors which have, in particular, a high temperature coefficient.

8. Method for amplifying an input voltage (VIN) into an output voltage (VOUT) with a temperature-stabilized overall gain factor, which specifies the amplification of the input voltage (VIN) into the output voltage (VOUT) and is a product of a first gain factor (S) and a second gain factor (R1), the following steps being implemented:

   (1) generation of an intermediate signal in the form of an intermediate current (I2) from the input voltage (VIN) and the first gain factor (S) by means of a current source (IREF) and a transconductance amplifier (OTA), at whose inputs (1, 2) the input voltage (VIN) is present and at whose output (3) the intermediate current can be coupled out, the current (I1) provided by the current source (IREF) and, dependent thereon, also the first gain factor (S) having opposite temperature dependencies with respect to the second gain factor (R1), and a MOS transistor (T1, T2) of the transconductance amplifier which is fed from the current source (IREF) via the source terminal being operated below the threshold voltage; and
   (2) generation of the output voltage (VOUT) from the intermediate signal (2) and the second gain factor (R1).

## Revendications

1. Circuit amplificateur ayant un facteur global d'amplification stabilisé en température, qui indique l'amplification d'une tension (VIN) d'entrée en une tension (VOUT) de sortie et qui est un produit d'un premier facteur (S) d'amplification et d'un deuxième facteur (R1) d'amplification, le circuit amplificateur comprenant :

   - des premiers moyens de production d'un signal intermédiaire sous la forme d'un courant (I2) intermédiaire à partir de la tension (VIN) d'entrée et du premier facteur (S) d'amplification, qui a

     - une source (IREF) de courant, et
     - un amplificateur (OTA) de transductance à l'entrée (1, 2) duquel s'applique la tension d'entrée et à la sortie (3) duquel peut sortir le courant (I2) intermédiaire, dans lequel

       - un transistor (T1, T2) MOS de l'amplificateur de transconducteur, cet amplificateur étant alimenté par l'intermédiaire de la borne de source par la source (IREF) de courant et amplifiant le signal fonctionne en dessous de la tension de seuil, et

   - des deuxièmes moyens de production de la tension (VOUT) de sortie à partir du signal (I2) intermédiaire et du deuxième facteur (R1) d'amplification, et dans lequel
   - le courant (I1) mis à disposition par la source (IREF) de courant et aussi le premier facteur (S) d'amplification qui en dépend ont des variations en fonction de la température qui sont opposées par rapport au deuxième facteur (R1) d'amplification.

2. Circuit amplificateur suivant la revendication 1, **caractérisé**

   - **en ce que** la source (IREF) de courant alimente un amplificateur différentiel de l'amplificateur (OTA) de transductance.

3. Circuit amplificateur suivant la revendication 1 ou 2, **caractérisé**

- **en ce que** les deuxièmes moyens comportent un amplificateur (OPA) opérationnel monté avec une résistance (R1) de convertisseur en convertisseur (CVC) courant-tension et transformant le courant (I2) intermédiaire en la tension (VOUT) de sortie.

4. Circuit amplificateur suivant la revendication 3, **caractérisé**

   - **en ce que** le courant (I2) mis à disposition par la source (IREF) de courant et la résistance (R1) de convertisseur ont des variations en fonction de la température qui sont opposées.

5. Circuit amplificateur suivant l'une ou plusieurs des revendications 2 à 4, **caractérisé**

   - **en ce que** la source (IREF) de courant comprend une rampe de source de courant, dont un transistor (T9) d'entrée est alimenté en un courant (ICONST) d'entrée stabilisé en température et qui a comme transistors de sortie au moins deux transistors (T10, T11) montés en parallèles, les courants de sortie produits par les sections drain-source des transistors (T10, T11) de sortie passant par au moins une résistance (R2) et alimentant conjointement l'amplificateur différentiel de l'amplificateur (OTA) de transductance.

6. Circuit amplificateur suivant l'une ou plusieurs des revendications précédentes, **caractérisé**

   - **en ce que** les premiers et les deuxièmes moyens sont intégrés à un substrat commun et le circuit amplificateur est notamment un circuit amplificateur CMOS.

7. Circuit amplificateur suivant l'une des revendications 5 et 6, **caractérisé**

   - **en ce que** la résistance (R1) de convertisseur et la au moins une résistance (R2) de la source (IREF) de courant sont des résistances intégrées linéaires qui ont notamment un grand coefficient de température.

8. Procédé d'amplification d'une tension (VIN) d'entrée en une tension (VOUT) de sortie avec un facteur global d'amplification stabilisé en température, qui indique l'amplification de la tension (VIN) d'entrée en la tension (VOUT) de sortie et qui est un produit d'un premier facteur (S) d'amplification et d'un deuxième facteur (R1) d'amplification, en effectuant les stades suivants :

(1) production d'un signal intermédiaire sous la forme d'un courant (I2) intermédiaire à partir de la tension (VIN) d'entrée et du premier facteur (S) d'amplification au moyen d'une source (IREF) de courant et d'un amplificateur (OTA) de transductance aux entrées (1, 2) duquel est appliquée la tension (VIN) d'entrée et de la sortie (3) duquel sort le courant intermédiaire, le courant (I1) mis à disposition par la source (IREF) de courant et également le premier facteur (S) d'amplification qui en dépend ayant des variations en fonction de la température qui sont opposées par rapport au deuxième facteur (R1) d'amplification, et fonctionnement d'un transistor (T1, T2) MOS de l'amplificateur de transductance, transducteur qui est alimenté par l'intermédiaire de la borne de source par la source (IREF) de courant, en dessous de la tension de seuil; et
(2) production de la tension (VOUT) de sortie à partir du signal (I2) intermédiaire et du deuxième facteur (R1) d'amplification.

OTA

CVC

Fig. 1     (Stand der Technik)

IREF

Fig. 2